# EUROPÄISCHE PATENTSCHRIFT

(11) **EP 1 099 954 B1**
(45) Veröffentlichungstag und Bekanntmachung des Hinweises auf die Patenterteilung: **29.11.2006**
(21) Anmeldenummer: 00203794.3
(22) Anmeldetag: 31.10.2000
(51) Int. Cl.: G01R 33/385

(54) **MR-Gerät**
MR apparatus
Appareil de RM

(30) Priorität: 09.11.1999 DE 19953748
(43) Veröffentlichungstag der Anmeldung: 16.05.2001
(73) Patentinhaber: Philips Intellectual Property & Standards GmbH, 20099 Hamburg (DE); Koninklijke Philips Electronics N.V., 5621 BA Eindhoven (NL)
(72) Erfinder: Overweg, Johannes Adrianus, Dr., 52064 Aachen (DE); Warmuth, Carsten, 52064 Aachen (DE); Leussler, Christoph Günther, 52064 Aachen (DE); Röschmann, Peter Karl Hermann, 52064 Aachen (DE)
(74) Vertreter: Volmer, Georg

(56) Entgegenhaltungen:
- EP-A- 0 313 213
- US-A- 5 574 373

## Beschreibung

Die Erfindung betrifft ein MR-Gerät
- mit einem zylinderförmigen Hauptfeldmagneten zur Erzeugung eines homogenen stationären Magnetfeldes, dessen Zylinderform eine Symmetrieachse definiert,
- mit einer die Symmetrieachse umschließenden, mehrere Gradientenspulen umfassenden Gradientenspulen-Anordnung,
- mit einer Hochfrequenzspulen-Anordnung, die mehrere gegeneinander versetzte, parallel zur Symmetrieachse verlaufende Leiter umfaßt, sich im Innern der Gradientenspulen-Anordnung befindet und mit dieser eine Kombination bildet,
- und mit einer Tischplatte zur Lagerung eines Untersuchungsobjektes.
Außerdem betrifft die Erfindung eine zur Verwendung in einem MR-Gerät geeignete Kombination aus einer Gradientenspulen-Anordnung und einer Hochfrequenzspulen-Anordnung.

Die zur Speisung einer Gradientenspule erforderliche elektrische Leistung hängt außer von der Geschwindigkeit, mit der der Strom durch die Gradientenspule ein- und ausgeschaltet wird, von deren Durchmesser ab, und zwar steigt die erforderliche elektrische Leistung etwa mit der 5. Potenz des Durchmessers. Deshalb macht man den inneren Durchmesser der Gradientenspulen-Anordnung in der Regel gerade so groß, dass der Hochfrequenzschirm, der sich unmittelbar auf der Innenseite der Gradientenspulen-Anordnung befindet und die Hochfrequenzspule nach außen hin abschirmen soll, von dieser einen hinreichend großen Abstand hat. Wenn man den Innendurchmesser der Gradientenspulen-Anordnung - und damit den Abstand des darin befindlichen Hochfrequenzschirms von der Hochfrequenzspulen-Anordnung - verringern würde, würde sich die für die Speisung der Gradientenspulen erforderliche elektrische Leistung zwar weiter reduzieren, doch würde dafür die zur Speisung der Hochfrequenzspule erforderliche Leistung zunehmen. Die Gradientenspule hat üblicherweise eine kreisförmige Innenkontur in Anpassung an die Hochfrequenzspule, deren parallel zur Symmetrieachse verlaufende Leiter auf einem Kreis um die Symmetrieachse angeordnet sind.

Aus der EP-OS 313 213 ist eine Gradientenspulen-Anordnung bekannt, bei der wenigstens eine der Gradientenspulen aus mehreren kreis- und ellipsenförmigen Segmenten derart zusammengesetzt ist, daß der Innenquerschnitt dieser Spulen in vertikaler Richtung geringere Abmessungen (14") hat als in horizontaler Richtung. Im Innern dieser Gradientenspule kann dann noch eine Hochfrequenzspule für Schädeluntersuchungen mit einem Durchmesser von 12" plaziert werden. Weiter ist angegeben, daß eine (oder mehrere) der Gradientenspulen sich aus einer Kombination von kreisförmigen, elliptischen oder auf andere Weise geformten Abschnitten zusammensetzen kann.

Es ist Aufgabe der vorliegenden Erfindung, ein MR-Gerät anzugeben, bei dem die für die Speisung der Gradientenspulen-Anordnung erforderliche elektrische Leistung noch weiter abgesenkt werden kann. Diese Aufgabe wird erfindungsgemäß durch die im Anspruch 2 angegebenen Maßnahmen gelöst.

Die Erfindung nutzt die Tatsache aus, daß der Raum unterhalb der Tischplatte des MR-Gerätes ohnehin nicht für die Lagerung des Patienten zur Verfügung steht. Deshalb befinden sich in diesem Bereich sowohl die Leiter der Hochfrequenzspulen-Anordnuog als auch die Gradientenspulen-Anordnung dichter an der Symmetrieachse als oberhalb der Tischplatte. Dadurch wird die zur Speisung der Gradientenspule erforderliche Leistung verringert im Vergleich zu einer Anordnung mit kreisförmigem Querschnitt der Hochfrequenzspulen-Anordnung und der Gradientenspulen-Anordnung.

Die Ausgestaltung nach Anspruch 3 bietet Vorteile bei der Herstellung der Gradientenspulen-Anordnung im Vergleich zu einer Gradientenspulen-Anordnung mit kreisförmigem Querschnitt.

Bei der Ausgestaltung nach Anspruch 4 kann die erforderliche elektrische Leistung für Gradientenspulen deren Magnetfeld einen Gradienten hat, dessen Richtung von der Richtung der Symmetrieachse abweicht, verringert werden. Außerdem wird die räumliche

Homogenität des von der Hochfrequenzspule erzeugten Feldes in Richtung der Symmetrieachse verbessert. Bei einer (kreis-), zylindrischen Form der Gradientenspulen-Anordnung hat das Hochfrequenz-Magnetfeld nämlich in deren Mitte ein ausgeprägtes Maximum. Dieses Maximum wird dadurch stärker abgeflacht bzw. verbreitert, dass in diesem Bereich die Gradientenspule - und damit auch der auf deren Innenseite befindliche Hochfrequenzschirm - den geringsten Abstand von der Hochfrequenzspule hat. Ein weiterer Vorteil dieser Anordnung besteht darin, dass die sogenannte Patientenöffnung in dem MR-Gerät sich nach außen hin erweitert, was den Zugang erleichtert und dem Patienten das Gefühl des Eingeschlossenseins nimmt.

Bei vorgegebenen Querschnitt einer Gradientenspulen-Anordnung kann gleichwohl deren Isozentrum (das ist die Stelle an der alle von den Gradientenspulen erzeugten Magnetfelder den Wert Null annehmen) innerhalb gewisser Grenzen frei gewählt werden, wenn die Windungen der einzelnen Gradientenspulen einen geeigneten räumlichen Verlauf haben. Wenn gemäß Anspruch 5 das Isozentrum oberhalb der Symmetrieachse liegt, ergeben sich hinsichtlich des Leistungsbedarfs besonders günstige Ausführungen der Gradientenspulen-Anordnung.

Die von der Gradientenspulen-Anordnung erzeugten Magnetfelder können in dem Metallgehäuse, in dem der Hauptfeldmagnet untergebracht ist, Wirbelströme hervorrufen, die zu Feldverzerrungen führen. Das Entstehen dieser Wirbelströme wird üblicherweise mittels einer aktiven Abschirmung unterdrückt, die die Gradientenspulen-Anordnung umschließt und die gleiche Anzahl von Spulen aufweist, wie die Gradientenspulen-Anordnung. Wenn diese Spulen die Form eines Kreiszylinders haben, dessen Mittelachse mit der Zentralachse zusammenfällt, führt dies bei der im Anspruch 2 angegebenen Ausgestaltung der Gradientenspulen dazu, dass das von den Gradientenspulen im Außenbereich erzeugte Magnetfeld oben stärker ist als unten, was dazu führen könnte, dass oben und/oder unten die Magnetfelder der Spulen der Abschirmung und der Gradientenspulen sich nicht mehr kompensieren können. Dies läßt sich durch die im Anspruch 6 angegebene Ausgestaltung vermeiden.

Wenn aber gemäß Anspruch 6 die Dichte der Windungen der Spulen der aktiven Abschirmung oberhalb der Symmetrieachse größer ist als unterhalb, dann ist auch das von dieser Spule erzeugte Magnetfeld oben größer als unten, so dass das von den korrespondierenden Gradientenspulen in ihrem Innern erzeugte Magnetfeld oberhalb der Symmetrieachse stärker geschwächt wird als unterhalb. Dieser Effekt läßt sich durch die Ausgestaltung nach Anspruch 7 vermeiden.

Anspruch 1 beschreibt eine für ein MR-Gerät vorgesehene erfindungsgemäße Kombination aus einer Hochfrequenzspulen-Anordnung und einer Gradientenspulen-Anordnung.

Die Erfindung wird nachstehend anhand der Zeichnungen näher erläutert. Es zeigen:
- Fig. 1: einen Querschnitt durch ein erfindungsgemäßes MR-Gerät,
- Fig. 2: einen Querschnitt einer weiteren Ausgestaltung,
- Fig. 3: den räumlichen Verlauf der Windungen auf einer Abwicklung einer Gradientenspule und
- Fig. 4: den räumlichen Verlauf der Windungen bei einer Abwicklung der zugehörigen Spule der aktiven Abschirmung.

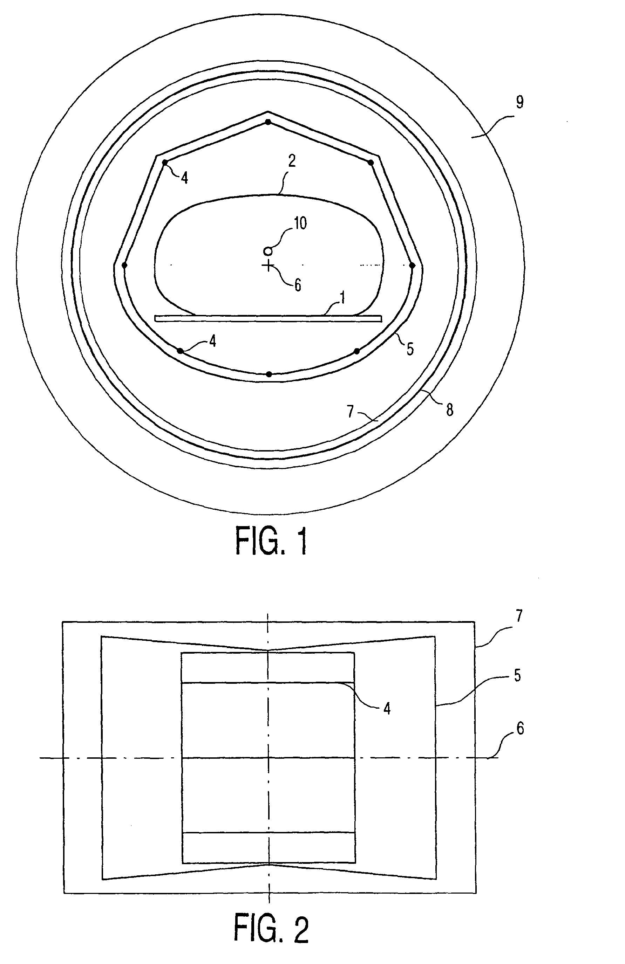

In Fig. 1 ist mit 1 eine Tischplatte zur Lagerung eines zu untersuchenden Objektes 2, beispielsweise eines Patienten, bezeichnet. Der für die Untersuchung zur Verfügung stehende Raum und die Tischplatte werden von einer Hochfrequenzspulen-Anordnung umschlossen - vorzugsweise vom bird-cage-typ - , die in diesem Beispiel acht zur Zeichenebene der Fig. 1 senkrecht verlaufende und daher durch einen Punkt symbolisierte Leiter 4 aufweist. Die oberhalb der Tischplatte befindlichen Leiter liegen - in einer zu einer Symmetrieachse 6 senkrechten Ebene - auf einem Kreisbogen um die Symmetrieachse. Die unterhalb der Tischplatte 1 befindlichen Leiter hingegen befinden sich auf einem Ellipsen-Halbbogen, dessen große Achse (punktiert angedeutet) horizontal verläuft. Die Enden dieser Leiter sind an beiden Seiten über je eine Leiterschleife miteinander verbunden, deren unterer Teil die Form einer Halbellipse und deren oberer Teil beispielsweise die Form eines Polyeders haben kann. Das von dieser Hochfrequenzspule erzeugte Magnetfeld verläuft senkrecht zur Zeichenebene.

Grundsätzlich könnte auch ein anderer Typ von Hochfrequenzspule benutzt werden, beispielsweise eine sogenannte Sattelspule oder ein sog. TEM-Resonator. Auch solche Spulen haben zueinander und zur Richtung des homogenen stationären Magnetfeldes parallel verlaufende Leiter.

Die Hochfrequenzspule mit den Leitern 4 wird von einer Gradientenspulen-Anordnung 5 umschlossen. Obwohl die Gradientenspulen-Anordnung 5 im Querschnitt nur durch eine einzige Linie dargestellt ist, besteht sie aus drei sich umschließenden Gradientenspulen. Jede Gradientenspule umfaßt eine 2,5 mm starke Lage von Leitern, und die Lagen sind durch 0,5 mm starke Zwischenlagen voneinander isoliert. Auf der Innenseite der innersten Gradientenspule ist ein nicht näher dargestellter Hochfrequenzschirm in Form einer 15 um dicken Kupferfolie aufgebracht. Der Abstand dieser Kupferfolie von den Leitern 4 der Hochfrequenzspule ist mit ca. 30 mm gerade so groß gewählt, dass die durch den Hochfrequenzschirm bewirkte Reduzierung des Hochfrequenzmagnetfeldes (bzw. die dadurch erforderliche Erhöhung der Hochfrequenzleistung) tolerierbar ist. Die Form des Querschnitts der Gradientenspule ist der Lage der Leiter 4 der Hochfrequenzspule bzw. der Form der sie miteinander verbindenden Leiterschleifen angepaßt.

Die drei Gradientenspulen können je ein zur Zeichenebene der Fig. 1 senkrecht verlaufendes magnetisches Feld mit zueinander senkrechten, d.h. in x-,y- und z-Richtung verlaufenden Gradienten erzeugen. Das Isozentrum 10 dieser Gradientenspulen-Anordnung, d.h. die Stelle, an der alle diese Magnetfelder den Wert Null annehmen, liegt oberhalb der Symmetrieachse 6 im geometrischen Zentrum der Gradientenspulen-Anordnung 5.

Weil die Leiter der Gradientenspulen-Anordnung in dem Bereich unterhalb der Tischplatte von der Symmetrieachse 6 einen geringeren Abstand haben als die Windungen oberhalb der Tischplatte, wird - bei gleicher magnetischer Feldstärke oberhalb der Tischplatte - die darin gespeicherte elektromagnetische Energie verringert (im Vergleich zu einer Spule mit kreisförmigem Querschnitt und einem Radius entsprechend dem Abstand der Symmetrieachse von dem am weitesten entfernten Abschnitt der Gradientenspulen-Anordnung). Deshalb verringert sich bei vorgegebener Stärke und Änderungsgeschwindigkeit des Gradienten die für die Speisung der einzelnen Gradientenspulen erforderliche elektrische Leistung. Es können daher leistungsschwächere Verstärker zur Erzeugung der Ströme in den Gradientenspulen benutzt werden.

Die Gradientenspulen-Anordnung 5 wird von einem zur Symmetrieachse 6 konzentrischen Kunststoffrohr 7 umschlossen, auf dessen Außenseite sich eine sogenannte aktive Abschirmung 8 für die Gradientenspulen-Anordnung 5 befindet. Die aktive Abschirmung 8 setzt sich ihrerseits wiederum aus drei Spulen mit einem zur Symmetrieachse 6 konzentrischen, kreisförmigen Querschnitt zusammen, von denen je eine von dem gleichen Strom durchflossen wird wie je eine der Gradientenspulen. Daher kompensieren sich die Magnetfelder dieser Spulen im Außenbereich, d.h. in dem Metallgehäuse eines Kryostaten 9, so dass darin praktisch keine Wirbelströme erzeugt werden. In dem Kryostaten 9 befindet sich ein nicht näher dargestellter supraleitender Magnet, der ein zur Zeichenebene senkrechtes stationäres Magnetfeld erzeugt, das - zumindest in dem von der Verkleidung 3 umschlossenen Bereich - weitgehend homogen ist. Die mechanische Verbindung zwischen dem Kryostaten 9 und den Komponenten 3-8 sind in der Zeichnung der Übersichtlichkeit halber nicht dargestellt.

Da die Gradientenspulen-Anordnung 5 einer geringere Fläche hat, während die aktive Abschirmung 8 weiterhin einen kreisförmigen Querschnitt hat, verringert sich auch die elektrische Durchflutung, die in der Abschirmung 8 erforderlich ist, um das Magnetfeld der Gradientenspulen-Anordnung 5 im Kryostaten 9 zu kompensieren. Dadurch verringert sich die erforderliche Leistung für die Gradientenspulen-Anordnung 5 (und die Abschirmung 8) noch weiter.

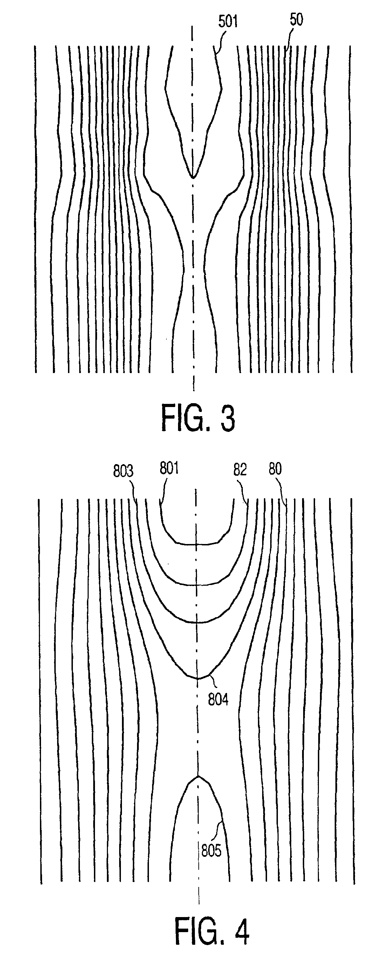

Üblicherweise haben die Gradientenspulen in Richtung senkrecht zur Symmetrieachse einen konstanten, d.h. von der Lage auf der Symmetrieachse unabhängigen Querschnitt. Dies kann auch bei der erfindungsgemäßen Anordnung so sein. Fig. 2 zeigt demgegenüber einen Längsschnitt durch ein MR-Gerät in einer die Symmetrieachse 6 enthaltenden Ebene bei einer modifizierten Ausführungsform der Erfindung. Der Querschnitt der Gradientenspulen-Anordnung und der Hochfrequenzspule haben dabei den in Fig. 1 dargestellten Verlauf.

Die Gradientenspulen-Anordnung 5 hat jedoch keinen geradlinigen Längsschnitt (damit ist der Querschnitt in einer die Zentralachse enthaltenden Ebene gemeint ), sondern einen von der Mitte der Hochfrequenzspule 4 nach außen konusförmig zunehmenden Längsschnitt. Die Gradientenspulen-Anordnung 5 - und damit der auf ihrer Innenseite angeordnete, nicht näher dargestellte Hochfrequenzschirm - ist durch diese Formgebung der Hochfrequenzspule 4 in der Mittelebene besonders nahe, was dazu führt, dass der Hochfrequenzschirm das Hochfrequenz-Magnetfeld in diesem Bereich stärker schwächt als außerhalb. Dadurch wird das Maximum, das das Hochfrequenz-Magnetfeld in diesem Bereich hat, flacher als sonst üblich, d.h. die räumliche Homogenität des Hochfrequenz-Magnetfeldes in Richtung der Zentralachse wird verbessert. Ein zusätzlicher Vorteil resultiert daraus, dass die seitlichen Öffnungen der Gradientenspulen-Anordnung vergrößert sind, so dass dort mehr Raum für den Patienten zur Verfügung steht, vorausgesetzt, dass die in Fig. 4 nicht näher dargestellte Verkleidung diesem Verlauf folgt.

Wenn die Gradientenspulen-Anordnung einen von der Kreisform abweichenden Querschnitt hat, wird die räumliche Konstanz des Gradienten des Magnetfeldes verringert. Dies läßt sich aber vermeiden, wenn die Leiterbahnen der einzelnen Gradientenspulen einen geeigneten - von dem bisher üblichen abweichenden - Verlauf haben. Dies wird im folgenden anhand der Fig. 3 und 4 erläutert. Diese Zeichnungen stellen jeweils die Abwicklung der rechten Hälfte der Gradientenspule mit in Richtung der Symmetrieachse verlaufendem Gradienten (Fig. 3) und derjenigen Spule der aktiven Abschirmung 8 dar, die von demselben Strom durchflossen wird und die das Magnetfeld der Gradientenspule im Außenbereich kompensiert (Fig. 4). Die Abwicklungen sind in verschiedenem Maßstab dargestellt.

Die nebeneinander in einer einzigen Windung befindlichen Leiterbahnen sind durch einen Strich symbolisiert. In Wirklichkeit sind diese Leiterbahnen aber breiter. Die einzelnen Windungen werden nacheinander von dem gleichen Strom durchflossen und zwar derart, dass die links von der Symmetrieebene liegenden Windungen bzw. Windungsabschnitte in derselben Richtung von diesem Strom durchflossen werden, während die Windungen bzw. Windungsabschnitte auf der rechten Seite in der entgegengesetzten Richtung vom Strom durchflossen werden, so dass sich der gewünschte Gradient ergibt. Mit konventionellen Spulen haben diese Spulen gemeinsam, dass die Zahl der Windungen 80 in der zur aktiven Abschirmung gehörenden Spule (Fig. 3) geringer ist als die Zahl der Windungen 50 in der Gradientenspule (Fig. 4). Dies ist durch die Tatsache begründet, dass die Spule der aktiven Abschirmung näher am Kryostaten liegen, so dass zur Erzeugung eines Magnetfeldes, das in der Innenwand des Kryostaten die gleiche Größe - aber die entgegengesetzte Richtung - hat, wie das von der Gradientenspule erzeugte Magnetfeld eine geringere elektrische Durchflutung bzw. weniger Windungen erforderlich sind.

Anders als bei konventionellen Spulen liegen die einzelnen Windungen jedoch nicht in einer zur Symmetrieachse senkrechten Ebene (wenn man von den äußersten Windungen absieht, für die dies näherungsweise der Fall ist) bzw. sie verlaufen nicht helixförmig. Insbesondere werden Windungsschleifen 801..805 bzw. 501 gebildet, wie sie sonst nur bei Gradientenspulen mit einem Gradienten in einer zur Symmetrieachse senkrechten Richtung benutzt werden. Durch diese Windungsschleifen wird die Windungszahl erhöht, und zwar oben (diese Windungen liegen auch oberhalb der Tischplatte) stärker als unten.

Die Gründe dafür liegen darin, dass die Windungen 50 oberhalb der Tischplatte 1 den Windungen 80 der Spule in der aktiven Abschirmung näher sind als unterhalb der Tischplatte (vgl. Fig. 1). Es sind daher oberhalb der Tischplatte 8 mehr Windungen erforderlich bzw. eine höhere elektrische Durchflutung, um das Feld der Gradientenspule 5 zu kompensieren. Da nun die Spule der aktiven Abschirmung oberhalb der Tischplatte mehr Windungen hat als unterhalb und da die oberhalb liegenden Windungen näher am Isozentrum 10 sind als die unterhalb liegenden Windungen, ist das von den oberhalb liegenden Windungen im Isozentraum erzeugte Magnetfeld stärker als das von den unterhalb befindlichen Windungen erzeugte, entgegengerichtete Feld. Um dem entgegen zu wirken, muß auch die Gradientenspule oberhalb der Tischplatte mehr Windungen haben als unterhalb und zwar auch dann, wenn - sich wie in Fig. 1 dargestellt - das Isozentrum 10 in der Mitte zwischen den oberen und den unteren Windungen befindet. Allerdings ist das Verhältnis zwischen den Windungszahlen oben und unten bei der Gradientenspule kleiner als bei der Spule der aktiven Abschirmung. Auch für die beiden anderen Gradientenspulen, die je ein Magnetfeld mit zueinander und zur Symmetrieachse senkrechten Gradienten erzeugen gilt, dass die Windungszahlen der Gradientenspulen oberhalb der Tischplatte größer sein müssen als unterhalb.

Wenn die Leiter 4 der Hochfrequenzspule so angeordnet sind wie in Fig. 1 dargestellt - also nicht gleichmäßig auf dem Umfang eines Kreises - um das Isozentrum 10, kann sich ein räumlich inhomogener Verlauf des Hochfrequenz-Magnetfeldes ergeben, weil einige Leiter dichter beim Isozentrum liegen als andere. Dem kann auf einfache Weise dadurch entgegengewirkt werden, dass der erwähnte (in der Zeichnung nicht dargestellt) Hochfrequenzschirm (und ggf. auch die Gradientenspule) etwas dichter an den Leitern 4 angeordnet wird, die einen geringeren Abstand zum Isozentrum haben.

## Patentansprüche

1. Kombination aus einer Gradientenspulen-Anordnung (5) und einer Hochnequenzspulen-Anordnung für ein MR-Gerät, wobei die Hochfrequenzspulen-Anordnung mehrere gegeneinander versetzte, parallel zu einer Achse (6) verlaufende Leiter (4) umfaßt und sich im Innern der Gradientenspulen-Anordnung (5) befindet, **dadurch gekennzeichnet, daß** ein Teil benachbarter Leiter (4) der Hochfrequenzspulen-Anordnung in einer zu der Achse senkrechten Ebene auf einem Kreisbogen um die Achse liegen, dessen Radius größer ist als die Abstände eines anderen Teils benachbarter Leiter von der Achse, und daß die Form des Querschnitts der Gradientenspulen-Anordnung senkrecht zu der Achse der Lage der Leiter der Hochfrequenzspulen-Anordnung in der Querschnittsebene angepaßt ist.

2. MR-Gerät
- mit einem zylinderförmigen Hauptfeldmagneten (9) zur Erzeugung eines homogenen stationären Magnetfeldes, dessen Zylinderform eine Symmetrieachse definiert,
- mit einer die Symmetrieachse umschließenden, mehrere Gradientenspulen umfassenden Gradientenspulen-Anordnung (5),
- mit einer Hochfrequenzspulen-Anordnung, die mehrere gegeneinander versetzte, parallel zur Symmetrieachse verlaufende Leiter (4) umfaßt, sich im Innern der Gradientenspulen-Anordnung (5) befindet, und mit dieser eine Kombination gemäß Anspruch 1 bildet,
- und mit einer Tischplatte (1) zur Lagerung eines Untersuchungsobjektes,
wobei die unterhalb der Tischplatte befindlichen Leiter (4) der Hochfrequenzspulen-Anordnung von der Symmetrieachse (6) einen geringeren Abstand haben als die oberhalb der Tischplatte befindlichen Leiter (4), deren Abstand von der Symmetrieachse gleich groß ist, und daß die Form des Querschnittes der Gradientenspulen-Anordnung senkrecht zur Symmetrieachse (5) der Lage der Leiter (4) der Hochfrequenzspulen-Anordnung in der Querschnittsebene angepaßt ist.

3. MR-Gerät nach Anspruch 2,
**dadurch gekennzeichnet,**
**dass** der Querschnitt der Gradientenspulen-Anordnung (5) zumindest über einen Teil seines Umfanges die Form eines Polyeders hat, dessen Ecken in der Nähe je eines der Leiter (4) liegen.

4. MR-Gerät nach Anspruch 2,
**dadurch gekennzeichnet,**
**dass** die Gradientenspulen-Anordnung (5) sich in Richtung der Symmetrieachse beidseitig nach außen hin erweitert.

5. MR-Gerät nach Anspruch 2,
**dadurch gekenntzeichnet**,
dass die Windungen der Spulen der Gradientenspulen-Anordnung (5) einen solchen räumlichen Verlauf haben, dass das Isozentrum (10) oberhalb der Symmetrieachse (6) liegt.

6. MR-Gerät nach Anspruch 2, mit einer die Gradientenspulen-Anordnung (5) umschließenden, mehrere Spulen umfassenden aktiven Abschirmung (8) zur Erzeugung von Magnetfeldern, die die von den Gradientenspulen erzeugten Magnetfelder im Außenbereich kompensieren,
**dadurch gekennzeichnet,**
**dass** die Dichte der Windungen (80) der Spulen der aktiven Abschirmung oberhalb der Symmetrieachse größer ist als unterhalb.

7. MR-Gerät nach Anspruch 6,
**dadurch gekennzeichnet,**
**dass** die Dichte der Windungen (50) der Gradientenspulen oberhalb der Symmetrieachse (6) größer ist als unterhalb.

## Claims

1. A combination of a gradient coil system (5) and an RF coil system for an MR apparatus, in which the RF coil system comprises a plurality of mutually offset conductors (4) extending parallel to an axis of symmetry (6) and is situated on the inside of the gradient coil system (5),
**characterized in that** part of adjacent conductors (4) of the RF coil system in a plane perpendicular to the axis of symmetry are situated on an arc of circle around the axis, the radius of which arc of circle is larger than the distances of another part of adjacent conductors from the axis, and that the form of the cross-section of the gradient coil system perpendicular to the axis is adapted to the position of the conductors of the RF coil system in the plane of cross-section.

2. An MR apparatus which includes
- a cylindrical main field magnet (9) for generating a uniform, steady magnetic field the cylindrical shape of which magnet defines an axis of symmetry,
- a gradient coil system (5) which encloses the axis of symmetry and includes a plurality of gradient coils,
- an RF coil system which is situated inside the gradient coil system (5) and includes a plurality of mutually offset conductors (4) which extend parallel to the axis of symmetry, forms a combination with it, and,
- a table top (1) for accommodating an object to be examined,
in which the conductors (4) of the RF coil system which are situated underneath the table top are situated at a smaller distance from the axis of symmetry (6) than the conductors (4) situated above the table top and whose distance between the axis of symmetry and the conductors (4) is equally large, and that the shape of the cross-section of the gradient coil system (5) perpendicular to the axis of symmetry is adapted to the position of the conductors (4) of the RF coil system in the plane of cross-section.

3. An MR apparatus as claimed in claim 2, **characterized in that** the cross-section of the gradient coil system (5) is shaped, at least over part of its circumference, as a polyhedron whose corners are situated in the vicinity of each time one of the conductors (4).

4. An MR apparatus as claimed in claim 2, **characterized in that** the gradient coil system (5) widens in the direction of the axis of symmetry.

5. An MR apparatus as claimed in claim 2, **characterized in that** the turns of the coils of the gradient coil system (5) extend in space in such a manner that the isocenter (10) is situated above the axis of symmetry (6).

6. An MR apparatus as claimed in claim 2 which includes an active shield (8) which encloses the gradient coil system (5) and includes a plurality of coils in order to generate magnetic fields which compensate the magnetic fields generated by the gradient coils in the outer region, **characterized in that** above the axis of symmetry the density of the turns (80) of the coils of the active shield is higher than that below the axis of symmetry.

7. An MR apparatus as claimed in claim 6, **characterized in that** above the axis of symmetry (6) the density of the turns (50) of the gradient coils is higher than that below the axis of symmetry.

## Revendications

1. Combinaison d'un montage de bobines à gradient (5) et d'un montage de bobines à haute fréquence pour un appareil de RM, le montage de bobines à haute fréquence comprenant plusieurs conducteurs (4) décalés les uns par rapport aux autres et s'étendant parallèlement à un axe (6) et se trouvant à l'intérieur du montage de bobines à gradient (5),
**caractérisée en ce**
**qu'**une partie des conducteurs voisins (4) du montage de bobines à haute fréquence se trouvent dans un plan perpendiculaire à l'axe sur un demi-cercle autour de l'axe dont le rayon est supérieur à la distance d'une autre partie de conducteurs voisins par rapport à l'axe et que la forme de la section du montage de bobines à gradient perpendiculairement à l'axe est adaptée à la position des conducteurs du montage de bobines à haute fréquence dans le plan de coupe.

2. Appareil de RM :
- avec un aimant de champ principal (9) de forme cylindrique pour la production d'un champ magnétique stationnaire homogène dont la forme cylindrique définit un axe de symétrie,
- avec un montage de bobines à gradient (5) comprenant plusieurs bobines à gradient et renfermant l'axe de symétrie,
- avec un montage de bobines à haute fréquence qui comprend plusieurs conducteurs (4) s'étendant parallèlement à l'axe de symétrie et décalés les uns par rapport aux autres et se trouve à l'intérieur du montage de bobines à gradient (5) et forme avec celui-ci une combinaison conformément à la revendication 1,
- et avec une table d'examen (1) pour y installer un objet d'examen dans lequel
les conducteurs (4) situés sous la table d'examen du montage de bobines à haute fréquence présentent par rapport à l'axe de symétrie (6) une distance moindre par rapport aux conducteurs (4) se trouvant au-dessus de la table d'examen dont la distance par rapport à l'axe de symétrie est de même taille et que la forme de la section du montage de bobines à gradient (5) perpendiculairement à l'axe de symétrie est adaptée à la position des conducteurs (4) du montage de bobines à haute fréquence dans le plan de la coupe transversale.

3. Appareil de RM selon la revendication 2,
**caractérisé en ce**
**que** la section du montage de bobines à gradient (5) possède, du moins sur une partie de sa périphérie, la forme d'un polyèdre dont les coins se trouvent respectivement à proximité d'un des conducteurs (4).

4. Appareil de RM selon la revendication 2,
**caractérisé en ce que**
le montage de bobines à gradient (5) s'élargit de part et d'autre vers l'extérieur en direction de l'axe de symétrie.

5. Appareil de RM selon la revendication 2,
**caractérisé en ce**
**que** les enroulements des bobines du montage de bobines à gradient (5) présentent un tracé spatial tel que l'isocentre (10) se trouve au-dessus de l'axe de symétrie (6).

6. Appareil de RM selon la revendication 2, avec un écran actif (8) comprenant plusieurs bobines et renfermant le montage de bobines à gradient (5) pour la production de champs magnétiques qui compensent les champs magnétiques produits par les bobines à gradient dans la zone extérieure,
**caractérisé en ce**
**que** la densité des enroulements (80) des bobines de l'écran actif est plus grande au-dessus de l'axe de symétrie qu'en dessous.

7. Appareil de RM selon la revendication 6,
**caractérisé en ce**
**que** la densité des enroulements (50) des bobines à gradient est plus grande au-dessus de l'axe de symétrie (6) qu'en dessous.
